# EUROPEAN PATENT APPLICATION

(11) **EP 3 125 290 A1**
(43) Date of publication of application: **01.02.2017**
(21) Application number: 15179394.0
(22) Date of filing: 31.07.2015
(51) Int. Cl.: H01L 23/495, H01L 23/49, G01R 33/00

(54) **ELECTRONIC DEVICE**

(71) Applicant: NXP B.V., 5656 AG Eindhoven (NL)
(72) Inventor: Saklang, Chayathorn, Redhill, Surrey RH1 1SH (GB); Tanwongwan, Wiwat, Redhill, Surrey RH1 1SH (GB)
(74) Representative: Terblanche, Candice Jane

(57) **Abstract**

A packaged electronic device is disclosed, comprising: a package, a die (204) and a first bondwire (212). The package comprises a leadframe. The leadframe comprises a first conducting leadframe element (208) and a second conducting leadframe element (206) that are separate from each other. The die (204) comprises a first bondpad. The first bondwire (212) electrically connects the first bondpad to the first conducting leadframe element (208). The die (204) mechanically couples the first and second leadframe elements (208, 206) together.

## Description

### Field

The present disclosure relates to a packaging arrangement for an electronic device or component, and more specifically to an arrangement of a die and lead frames.

### Background

Electronic devices, such as integrated circuits or sensors often comprise electrical connections, by which such components may be connected into a larger system. It is also often the case that electronic devices are placed in a package, which protects the device and provides a standardised set of electrical connections to and from the device.

Electronic devices may take the form of a die, which may comprise a semiconductor substrate such as silicon. Conventionally, conducting regions (bondpads) are exposed at the surface of the die for making electrical connections to the die, and these electrically conducting regions may be in turn connected, using bondwires, to electrical conductors of the package (i.e. to the package lead-frame).

The package lead-frame may comprise a metal such as copper. The package may further comprise a polymeric encapsulating material such as a plastic material. A mismatch in CTE (coefficient of thermal expansion) may therefore exist between the various elements of the device, including the die and various elements of the package.

When the packaged electronic device is subject to temperature variation, differential expansion between elements of the packaged device may result in thermally induced stress cycles on bondwires connecting the bondpads to the leadframe. Such stresses may lead to premature failure of the bondwire, resulting in failure of the device.

A packaging arrangement that reduces the incidence of such failures is desirable.

### Summary

According to a first aspect, there is provided a packaged electronic device comprising: a package, a die and a first bondwire. The package comprises a leadframe. The leadframe comprises a first and second conducting leadframe element that are separate from each other. The die comprises a first bondpad. The first bondwire electrically connects the first bondpad to the first leadframe element. The die mechanically couples the first and second leadframe elements together.

The mechanical coupling together of the first and second leadframe elements by the die may substantially reduce thermally induced strain on the first bondwire, resulting in improved reliability of the overall device.

The die may further comprise a second bondpad. The device may further comprise a second bondwire. The second bondwire may connect the second bondpad to the second leadframe element.

The die may be coupled to the first and second leadframe elements by an adhesive layer.

A connection between the first bondwire and the first bondpad and/or first leadframe element may comprise a wedge bond.

The device may further comprise an encapsulating element that fully encapsulates the die, first bondpad and first bondwire. The encapsulating element may partially encapsulate the first and second leadframe elements, so that the first and second leadframe elements protrude from the encapsulating element.

The first and second leadframe elements may each comprise elongate bodies extending away from the first die in substantially the same direction.

The first leadframe element may comprise a first end that is proximate to the die, and a second end that is remote from the die. A first distance from the die to the second end may be at least five times the dimension of the die (or the encapsulating element) in the direction of the first distance.

The device may further comprise a further die coupled to the first and/or second leadframe element.

The die may be coupled to a first surface of the second leadframe element, and a further component may be coupled to a second opposite surface of the second leadframe element.

A further encapsulating element may be provided between the first encapsulating element and the second ends of the respective first and second leadframe elements. The further encapsulating element may surround adjacent portions of the respective first and second leadframe elements.

The device may comprise a magnetic field sensor. The device may be for use in a rotational speed sensor.

According to a second aspect, there is provided a rotational speed sensor comprising a device according to any preceding claim.

According to a third aspect, there is provided an anti-lock braking system comprising the speed sensor according to the second aspect.

These and other aspects of the invention will be apparent from, and elucidated with reference to, the embodiments described hereinafter.

### Brief description of Drawings

Embodiments will be described, by way of example only, with reference to the drawings, in which
figure 1 is an isometric view of a packaged electronic device, with a polymer encapsulated die on a lead frame;
figure 2 is a plan view of the device of figure 1;
figure 3 is an isometric view of a packaged electronic device according to an embodiment, with a polymer encapsulated die on a lead frame;
figure 4 is a plan view of the device of figure 3;
figure 5 is a detail view of a first end of the lead frame elements of figure 3, including the die and associated wire bonds;
figure 6 is a graph comparing strain levels for a wire bond in the arrangement of figure 1, and for the arrangement of figure 3, in accordance with an embodiment; and
figure 7 is a schematic of an ABS (anti-lock braking system) speed sensor according to an embodiment comprising a device similar to that shown in figure 3, encapsulated with an over-moulded polymer material.

It should be noted that the drawings are diagrammatic and not drawn to scale. Relative dimensions and proportions of parts of these drawings have been shown exaggerated or reduced in size, for the sake of clarity and convenience in the drawings. The same reference signs are generally used to refer to corresponding or similar features in modified and different embodiments.

### Detailed description of embodiments

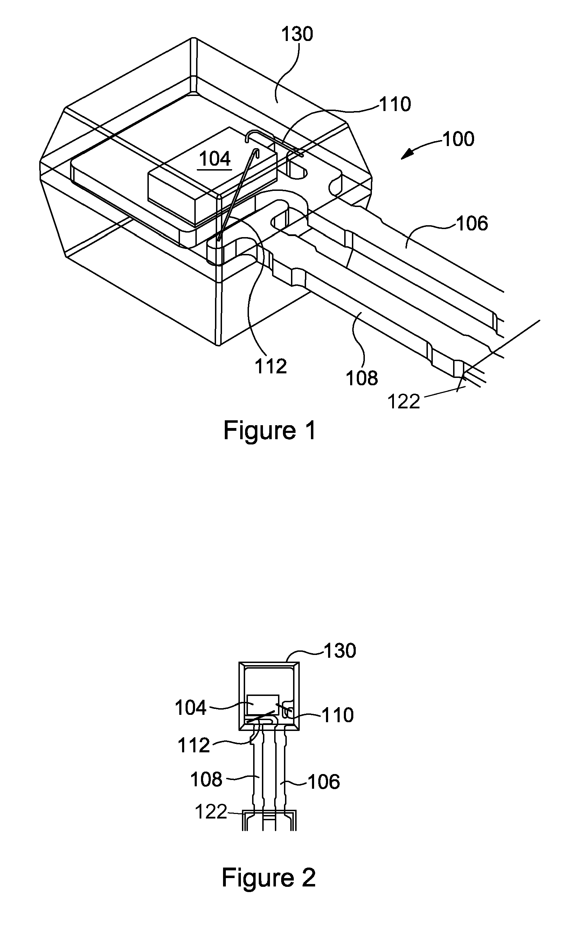

Figures 1 and 2 show a device 100, comprising a die 104, first leadframe element 108, second leadframe element 106, encapsulating element 130, further encapsulating element 122, first bondwire 112 and second bondwire 110.

The die 104 may comprise a sensor, such as a magnetic field sensor (which may be a Hall sensor, an AMR sensor, or some other sensor). The die 104 may comprise an integrated circuit, and may comprise a readout circuit for the sensor. The die 104 may comprise a silicon substrate, or a substrate of some other semiconductor material.

The die 104 in this arrangement is supported by the second leadframe element 106, which comprises a paddle shaped region at a first end thereof, to which the die 104may be attached, for instance by an adhesive layer. The die 104may be attached to a first surface of the second leadframe element 106 and a further component (not shown) may be attached to a second, opposite surface of the second leadframe element 106.

The die 104 comprises a first and second bondpad, each for making electrical connections to the first die 104. The first bondwire 112 connects the first bondpad to the first lead frame element 108, and the second bondwire 110 connects the second bondpad to the second leadframe element 106.

The encapsulating element 130 is substantially cuboid in shape, having sidewalls that taper inwards away from the plane of the first and second leadframe elements 108, 106. The encapsulating element 130 fully surrounds the die 104 and the paddle shaped region at the first end of the second leadframe element 106. The first and second bondwires 112, 110 are also surrounded by the encapsulating element 130. The encapsulating element 130 may comprise a polymeric material, such as a plastics material, and may be overmoulded over the components it surrounds. The first and second leadframe elements 106, 108 both protrude from the same sidewall of the encapsulating element 130, and extend away in finger-like elongate protrusions.

The first and second leadframe elements 108, 106 are more clearly shown in figure 2. The first and second leadframe 108, 106 in the arrangement of figures 1 and 2 arrangement are mechanically coupled together at their respective first ends only by the encapsulating element 130. A further encapsulating element 122 is provided to mechanically couple the first and second leadframe elements 108, 106 together at a distance from the encapsulating element 130 (this distance may be larger than the extent of the encapsulating element 130 in the same direction).

The first and second leadframe elements 108, 106 extend in substantially the same direction side-by-side away from the further encapsulating element 122. The distance between the first and second leadframe elements 108, 106 may increase in a number of steps as the distance from the encapsulating element 130 increases. The first and second leadframe elements 108, 106 may respectively comprise a second end. The second ends may comprise electrical connectors, suitable for connecting to a plug or socket. The first and second leadframe elements 108, 106 may protrude a first distance away from the encapsulating element 130 (i.e. from the edge of the encapsulating element 130 to the second ends). The first distance may be at least five times the dimension of the encapsulating element, measured in the same direction as the first distance (i.e. the leadframe elements 108, 106 extend for a relatively long way from the encapsulating element 130).

The first and second leadframe elements 108, 106 may each comprise a layer of copper, with a coating to protect from corrosion. The coating (for instance in the bondwire attachment regions of the leadframe elements) may comprise nickel, and/or nickel and palladium.

When the packaged device 100 is subject to temperature cycling, differential expansion between the various elements of the device may lead to a change in the distance between the die 104 and the first end of the first leadframe element 108. This in turn may result in a thermally induced strain on the first bondwire (which may extend between the die 104 and the first end of the first leadframe element 108). This thermally induced strain may, over time, result in failure of the first bondwire 112, for instance due to fatigue. Such failures may tend to occur near the point of attachment of the first bondwire 112 to the first leadframe element 108, which may approximately correspond with a location of maximum reversed stress. This may limit the service lifetime of the device 100.

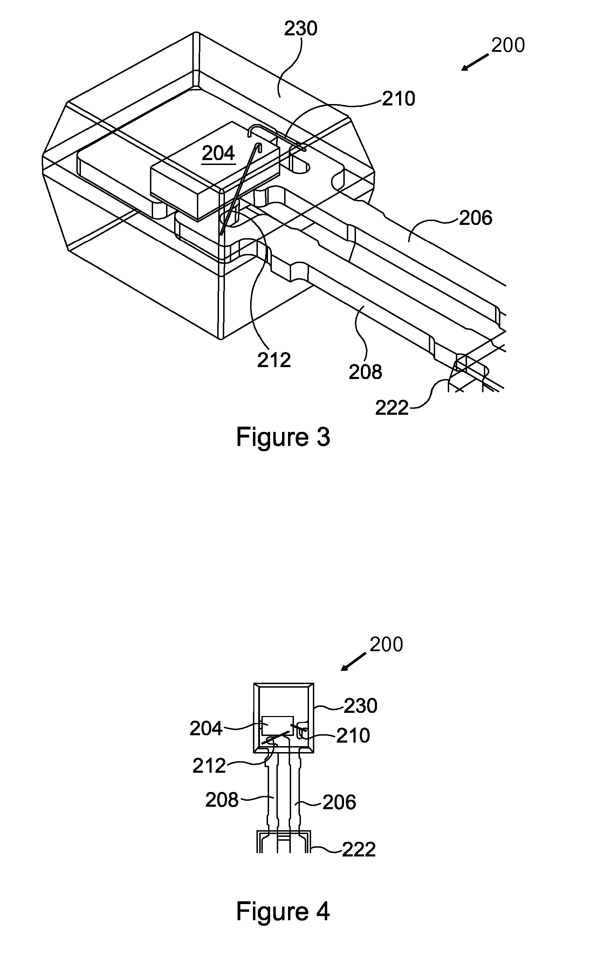

Figures 3 and 4 depict a device 200 in accordance with an embodiment. The device 200 has a number of features in common with the arrangement of figures 1 and 2. The device 200 of figures 3 and 4 comprises a die 204, first leadframe element 208, second leadframe element 206, encapsulating element 230, further encapsulating element 222, first bondwire 212 and second bondwire 210. The device 200 may comprise all the elements that are found in the device 100 of figures 1 and 2. Each of the features described with reference to figure 1 and figure 2 may be applicable to the device of figures 3 and 4 (with similar features given a reference numeral starting with '2' instead of '1'). However, in the device 200 of figures 3 and 4, the features within the encapsulating element 230 are arranged differently.

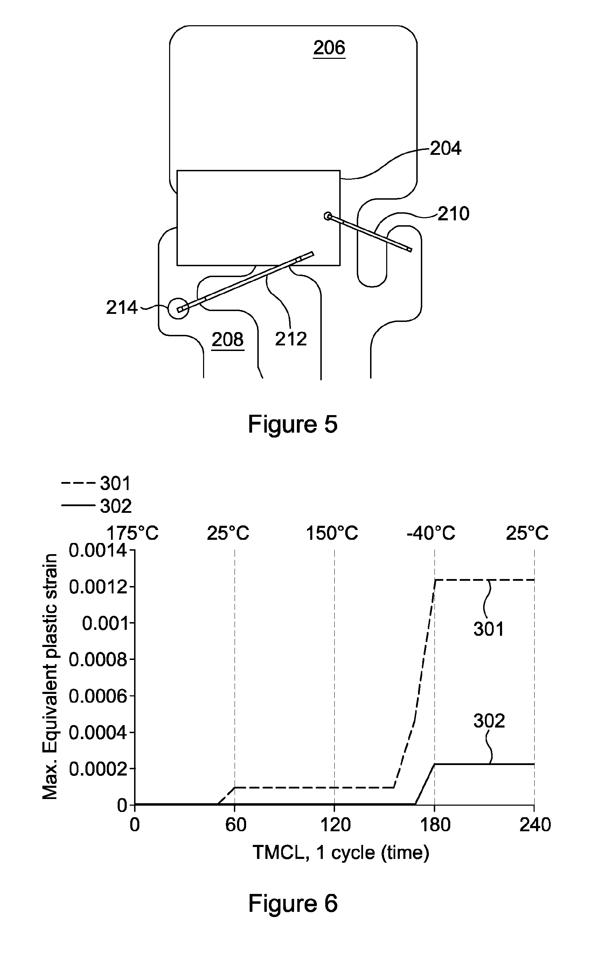

In the device 200 of figure 3, the design of the first and second leadframe elements 208, 206 has been modified. As is more clearly shown in figure 5, the first bondwire 212 electrically connects the die 204 to the first end of the first leadframe element 208. The second bondwire 210 connects the die 204 to the second leadframe element 206. In an embodiment, the die 204 mechanically couples the first end of the first and second leadframe elements 208, 206 together. This reduces or prevents relative movement between the die 204 and the first end of the first leadframe element 208, substantially reducing the amount of thermally induced strain on the first bondwire 212. The design of the first end of each of the first and second leadframe elements 208, 206 has been altered to enable the die 204 to straddle the gap between the paddle at the first end of the second leadframe element 206 and the first end of the first leadframe element 208. The design changes are such that the external design on the leadframe elements 208, 206 and encapsulation elements 230, 222 remain unchanged, so that an embodiment may provide a more reliable replacement for the device of figure 1. The die 204 may be attached to both the first and second leadframe elements 208, 206 by an adhesive layer (not shown). A further die (not shown) may be included on the first or second leadframe element 208, 206.

Figure 6 shows a plot of maximum equivalent plastic strain in the first bondwire 112, 212 arising over a temperature cycle due to a mismatch in TCE between the various materials of the packaged device for: a device according to figure 1 301, and a device according an embodiment, shown in figure 3, 302. The results 301, 302 are based on finite element simulations of the packaged devices, and clearly show a substantial reduction in the maximum thermally induced strain as a result of temperature cycling for a device according to an embodiment. The maximum equivalent plastic strain may occur at or near a bond between the bondwire and the leadframe. The bond may be a wedge bond (or a ball bond).

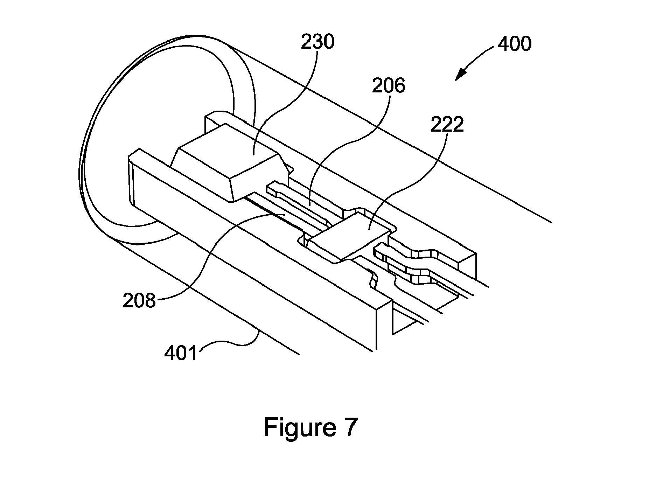

As shown in figure 7, the device 200 may be included within an overmoulded exterior package 401 to form an encapsulated device 400 that may include a connector sleeve (not shown) for receiving a removable connector that electrically couples to the second ends of the leadframe elements 208, 206.

From reading the present disclosure, other variations and modifications will be apparent to the skilled person. Such variations and modifications may involve equivalent and other features which are already known in the art of electronic device packaging, and which may be used instead of, or in addition to, features already described herein.

Although the appended claims are directed to particular combinations of features, it should be understood that the scope of the disclosure of the present invention also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention.

Features which are described in the context of separate embodiments may also be provided in combination in a single embodiment. Conversely, various features which are, for brevity, described in the context of a single embodiment, may also be provided separately or in any suitable sub-combination. The applicant hereby gives notice that new claims may be formulated to such features and/or combinations of such features during the prosecution of the present application or of any further application derived therefrom.

For the sake of completeness it is also stated that the term "comprising" does not exclude other elements or steps, the term "a" or "an" does not exclude a plurality and reference signs in the claims shall not be construed as limiting the scope of the claims.

## Claims

**1.** A packaged electronic device comprising:
a package having a leadframe, the leadframe comprising a first and second conducting leadframe element that are separate from each other;
a die, comprising a first bondpad; and
a first bondwire electrically connecting the first bondpad to the first leadframe element;
wherein the die mechanically couples the first and second leadframe elements together.

**2.** The device of claim 1, the die further comprising a second bondpad and the device comprising a second bondwire, connecting the second bondpad to the second leadframe element.

**3.** The device of any preceding claim, wherein the die is coupled to the first and second leadframe elements by an adhesive layer.

**4.** The device of any preceding claim, wherein a connection between the first bondwire and the first bondpad and/or first leadframe element comprises a wedge bond.

**5.** The device of any preceding claim, further comprising an encapsulating element that fully encapsulates the die, first bondpad and first bondwire, and partially encapsulates the first and second leadframe elements, so that the first and second leadframe elements protrude from the encapsulating element.

**6.** The device of claim 5, wherein the first and second leadframe elements each comprise elongate bodies extending away from the die in substantially the same direction.

**7.** The device of claim 6, wherein the first leadframe element comprises a first end that is proximate to the die, and a second end that is remote from the first die, wherein a first distance from the first die to the second end is at least five times the dimension of the die in the direction of the first distance.

**8.** The device of any of claims 5 to 7, further comprising a further die coupled to the first and/or second leadframe element.

**9.** The device of any preceding claim, wherein the die is coupled to a first surface of the second leadframe element, and a further component is coupled to a second opposite surface of the second leadframe element.

**10.** The device of any of claims 5 to 9, wherein a further encapsulating element is provided between the first encapsulating element and the second ends of the respective first and second leadframe elements, the further encapsulating element surrounding adjacent portions of the respective first and second leadframe elements.

**11.** The device of any preceding claim, wherein the device comprises a magnetic field sensor.

**11.** A rotational speed sensor comprising a device according to any preceding claim.

**12.** An anti-lock brake system comprising the speed sensor of claim 11.
